# DEMANDE DE BREVET EUROPEEN

(11) **EP 4 174 946 A1**
(43) Date de publication de la demande: **03.05.2023**
(21) Numéro de dépôt: 22203892.9
(22) Date de dépôt: 26.10.2022
(51) Int. Cl.: H01L 27/06, H01L 29/78, H01L 23/34, H01L 29/40, H01L 29/861

(54) **DISPOSITIF ÉLECTRONIQUE COMPRENANT DES TRANSISTORS**

(30) Priorité: 29.10.2021 FR 2111559
(71) Demandeur: STMicroelectronics (Rousset) SAS, 13790 Rousset (FR)
(72) Inventeur: GERMANA-CARPINETO, Rosalia, 06600 ANTIBES (FR); MASOERO, Lia, 13006 MARSEILLE (FR)
(74) Mandataire: Cabinet Beaumont

(57) **Abrégé**

La présente description concerne un dispositif électronique (100) comprenant un substrat semiconducteur (102), des transistors (T) dont les grilles (120) sont contenues dans des premières tranchées (170) s'étendant dans le substrat et au moins un composant électronique (200), différent d'un transistor, formé au moins en partie dans une première région semiconductrice (210) contenue dans une deuxième tranchée (202) s'étendant dans le substrat semiconducteur parallèlement aux premières tranchées.

## Description

### Domaine technique

La présente description concerne de façon générale les dispositifs électroniques, et plus particulièrement des dispositifs électroniques comprenant des transistors.

### Technique antérieure

Dans certains dispositifs électroniques, des transistors à effet de champ sont utilisés à un état non passant pour bloquer des tensions élevées, typiquement supérieures à 10 V, par exemple de l'ordre de 40 V, voire supérieures à 100 V.

De tels dispositifs peuvent comprendre des circuits de protection des transistors comprenant notamment un capteur de la température au niveau des transistors permettant de commander de façon adaptée les transistors en fonction de la température mesurée. Le capteur de température peut comprendre différents composants électroniques, notamment au moins une résistance et au moins une diode polarisée en direct, la tension aux bornes de la diode étant représentative de la température au niveau de la diode. Il est souhaitable que la diode utilisée pour la mesure de la température des transistors soit située au plus proche des transistors.

### Résumé de l'invention

Un objet d'un mode de réalisation est de prévoir un dispositif électronique comprenant des transistors et au moins un composant électronique supplémentaire palliant tout ou partie des inconvénients des transistors existants.

Selon un objet d'un mode de réalisation, la distance entre le composant électronique et les transistors est réduite.

Selon un objet d'un mode de réalisation, les étapes de fabrication du composant électronique et les étapes de fabrication des transistors sont au moins en partie communes.

Un mode de réalisation prévoit un dispositif électronique comprenant un substrat semiconducteur, des transistors dont les grilles sont contenues dans des premières tranchées s'étendant dans le substrat et au moins un composant électronique, différent d'un transistor, formé au moins en partie dans une première région semiconductrice contenue dans une deuxième tranchée s'étendant dans le substrat semiconducteur parallèlement aux premières tranchées.

Selon un mode de réalisation, le dispositif électronique comprend, en outre :
- un premier élément conducteur électriquement situé dans la deuxième tranchée, la première région semiconductrice s'étendant dans le premier élément conducteur électriquement ;
- une première couche isolante électriquement entre le premier élément conducteur électriquement et le substrat semiconducteur ; et
- une deuxième couche isolante électriquement entre la première région semiconductrice et le premier élément conducteur électriquement.

Selon un mode de réalisation, le dispositif électronique comprend, en outre :
- au moins une troisième tranchée s'étendant dans le substrat semiconducteur au moins sur une partie le long de la deuxième tranchée, entre la deuxième tranchée et l'une des premières tranchées ;
- un deuxième élément conducteur électriquement contenu dans la troisième tranchée ; et
- une troisième couche isolante électriquement entre le deuxième élément conducteur électriquement et le substrat semiconducteur.

Selon un mode de réalisation, le dispositif électronique comprend deux troisièmes tranchées s'étendant dans le substrat semiconducteur de part et d'autre de la deuxième tranchée.

Selon un mode de réalisation, chaque troisième tranchée est totalement disjointe de la deuxième tranchée.

Selon un mode de réalisation, chaque troisième tranchée rejoint à chaque extrémité la deuxième tranchée, le deuxième élément conducteur électriquement étant jointif avec le premier élément conducteur électriquement.

Selon un mode de réalisation, le dispositif électronique comprend, en outre :
- une quatrième tranchée s'étendant dans le substrat semiconducteur et entourant complètement la deuxième tranchée et chaque troisième tranchée, les premières tranchées étant du côté de la quatrième tranchée opposé à la deuxième tranchée ;
- un troisième élément conducteur électriquement contenu dans la quatrième tranchée ; et
- une quatrième couche isolante électriquement entre le troisième élément conducteur électriquement et le substrat semiconducteur.

Selon un mode de réalisation, chaque transistor comprend :
- une cinquième couche isolante électriquement entre la grille du transistor et le substrat semiconducteur et formant l'isolant de grille du transistor ;
- un quatrième élément conducteur électriquement situé dans la première tranchée ;
- une sixième couche isolante électriquement entre le quatrième élément conducteur électriquement et le substrat semiconducteur ;
- une septième couche isolante électriquement entre le quatrième élément conducteur électriquement et la grille ;
- une deuxième région semiconductrice du substrat semiconducteur, délimitée par la première tranchée contenant la grille ; et
- un caisson semiconducteur en contact avec la deuxième région semiconductrice et l'isolant de grille, et dans lequel est situé le canal du transistor.

Selon un mode de réalisation, la première région semiconductrice est dopée d'un premier type de conductivité, le dispositif électronique comprenant, en outre, au moins des troisième et quatrième régions semiconductrices s'étendant dans la première région semiconductrice et plus fortement dopées que la première région semiconductrice.

Selon un mode de réalisation, le dispositif électronique comprend des deuxièmes tranchées s'étendant dans le substrat semiconducteur et des premières régions semiconductrices contenues chacune dans l'une des deuxièmes tranchées, chaque première région semiconductrice étant dopée d'un premier type de conductivité, le dispositif électronique comprenant, en outre, des troisième et quatrième régions semiconductrices s'étendant dans chaque première région semiconductrice et plus fortement dopées que les premières régions semiconductrices.

Selon un mode de réalisation, le dispositif électronique comprend des troisièmes et quatrièmes régions semiconductrices s'étendant dans la première région semiconductrice et plus fortement dopées que la première région semiconductrice.

Selon un mode de réalisation, les troisièmes régions semiconductrices sont connectées électriquement en parallèle et les quatrièmes régions semiconductrices sont connectées électriquement en parallèle.

Selon un mode de réalisation, au moins l'une des troisièmes régions semiconductrices est connectée électriquement en série à l'une des quatrièmes régions semiconductrices.

Selon un mode de réalisation, le composant électronique est une diode, la troisième région semiconductrice étant dopée du premier type de conductivité et la quatrième région semiconductrice étant dopée d'un deuxième type de conductivité opposé au premier type de conductivité.

Selon un mode de réalisation, le composant électronique est une résistance, les troisième et quatrième régions semiconductrices étant dopées du premier type de conductivité.

Un mode de réalisation prévoit également un procédé de fabrication du dispositif électronique tel que défini précédemment, dans lequel les premières tranchées et la deuxième tranchée sont formées simultanément.

Un mode de réalisation prévoit également l'utilisation du dispositif électronique tel que défini précédemment, dans lequel, en fonctionnement, le premier élément conducteur électriquement et le deuxième élément conducteur électriquement sont connectés électriquement à une source d'un potentiel de référence.

Selon un mode de réalisation, en fonctionnement, le troisième élément conducteur électriquement est connecté électriquement aux quatrièmes éléments conducteurs électriquement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe latérale, partielle et schématique, d'un exemple de transistor à canal vertical ;
la figure 2A est une vue de dessus, partielle et schématique, d'un mode de réalisation d'un dispositif électronique comprenant des transistors et un composant électronique supplémentaire ;
la figure 2B est une vue en coupe latérale, partielle et schématique, du dispositif de la figure 2A ;
la figure 2C est une autre vue en coupe latérale, partielle et schématique, du dispositif de la figure 2A ;
la figure 2D est une autre vue en coupe latérale, partielle et schématique, du dispositif de la figure 2A ;
la figure 3 est une vue en perspective avec coupe, partielle et schématique, du dispositif des figures 2A à 2D ;
la figure 4 est une vue en coupe latérale, partielle et schématique, analogue à la figure 2B illustrant un mode de réalisation des connexions des éléments du dispositif représenté sur les figures 2A à 2D et 3 ;
la figure 5 est une vue de dessus, partielle et schématique, d'un mode de réalisation du dispositif représenté sur les figures 2A à 2D et 3 ;
la figure 6 est une vue de dessus, partielle et schématique, d'un autre mode de réalisation du dispositif représenté sur les figures 2A à 2D et 3 ;
la figure 7 est une vue de dessus, partielle et schématique, d'une variante du dispositif représenté sur la figure 5 ;
la figure 8 est une vue en coupe latérale, partielle et schématique, analogue à la figure 2B illustrant un mode de réalisation des connexions des éléments du dispositif représenté sur la figure 7 ;
la figure 9 est une vue en coupe latérale, partielle et schématique, analogue à la figure 2B illustrant un autre mode de réalisation des connexions des éléments du dispositif représenté sur la figure 7 ;
la figure 10A illustre une étape d'un mode de réalisation d'un procédé de fabrication du dispositif représenté sur les figures 2A à 2D et 3 ;
la figure 10B illustre une autre étape du procédé ;
la figure 10C illustre une autre étape du procédé ;
la figure 10D illustre une autre étape du procédé ;
la figure 10E illustre une autre étape du procédé ;
la figure 10F illustre une autre étape du procédé ;
la figure 10G illustre une autre étape du procédé ;
la figure 10H illustre une autre étape du procédé ;
la figure 11A illustre une étape d'un mode de réalisation d'un procédé de fabrication du dispositif représenté sur les figures 2A à 2D et 3 ;
la figure 11B illustre une autre étape du procédé ;
la figure 11C illustre une autre étape du procédé ;
la figure 11D illustre une autre étape du procédé ;
la figure 11E illustre une autre étape du procédé ;
la figure 11F illustre une autre étape du procédé ;
la figure 11G illustre une autre étape du procédé ;
la figure 11H illustre une autre étape du procédé ;
la figure 12 est une vue en coupe latérale, partielle et schématique, du dispositif représenté sur les figures 2A à 2D et 3 illustrant, par des niveaux de gris, les variations du potentiel électrostatique dans le dispositif dans une première configuration de fonctionnement ;
la figure 13 est une vue de détail de la figure 12 ;
la figure 14 est une vue analogue à la figure 12 dans une deuxième configuration de fonctionnement ;
la figure 15 est une vue de détail de la figure 14 ;
la figure 16 est une vue analogue à la figure 12 dans une troisième configuration de fonctionnement ;
la figure 17 est une vue de détail de la figure 16 ; et
la figure 18 est une vue en coupe latérale, partielle et schématique, d'un mode de réalisation d'un dispositif comprenant des transistors et un composant électronique supplémentaire.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, des étapes de fabrication de masques, des étapes de dopage, et de fabrication de bornes connectées électriquement à des zones dopées ne sont pas détaillées, les modes de réalisation décrits étant compatibles avec des telles étapes usuelles.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments. En outre, on considère ici que les termes "isolant" et "conducteur" signifient respectivement "isolant électriquement" et "conducteur électriquement".

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un écran d'affichage dans une position normale d'utilisation.

Sauf précision contraire, les expressions "environ", "approximativement", "sensiblement", et "de l'ordre de" signifient à 10 % près, de préférence à 5 % près. Sauf précision contraire, les adjectifs numéraux ordinaux, tels que "premier", "deuxième", etc., sont utilisés seulement pour distinguer des éléments entre eux. En particulier, ces adjectifs ne limitent pas les modes de réalisation décrits à un ordre particulier de ces éléments.

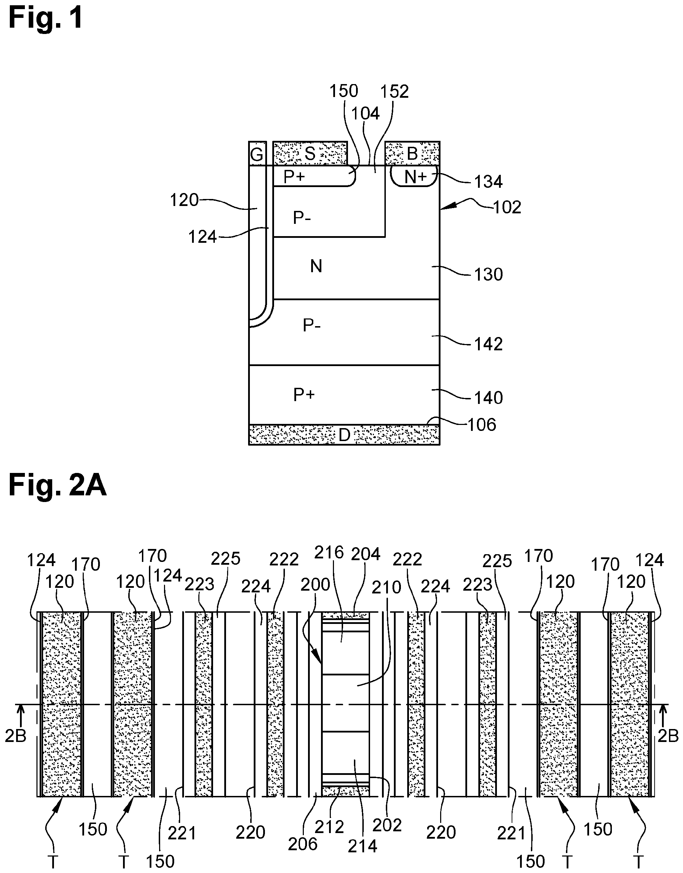

La figure 1 est une vue en coupe, partielle et schématique, d'un exemple de transistor T. Le transistor T est formé dans et sur un substrat semiconducteur 102 comprenant une face avant 104 et une face arrière 106, opposée à la face avant 104. Le transistor T comprend notamment :
- une grille 120 connectée à une borne de commande G du transistor ;
- un caisson semiconducteur 130 séparé de la grille 120 par un isolant de grille 124 et dans lequel se forme en fonctionnement le canal du transistor T. Le caisson 130 est de préférence connecté, par l'intermédiaire d'une zone de prise de contact 134, à une borne B, dite borne de caisson du transistor ;
- des zones dopées 140 et 150 de drain/source situées de part et d'autre du caisson 130. La zone dopée 140 est en contact avec une borne S de conduction, et la zone dopée 140 est en contact avec une borne D de conduction. La borne de conduction S peut être du côté de la face avant 104 du substrat 102 et la borne de conduction D peut être du côté de la face arrière 106 du substrat 102 ; et
- des régions semiconductrices 142, 152 dite régions de dérive. La région semiconductrice 142 est interposée entre la zone dopée 140 et le caisson 130 et la région semiconductrice 152 est interposée entre la zone dopée 150 et le caisson 130. Au moins l'une des régions semiconductrices 142, 152 peut ne pas être présente. La distance séparant le caisson 130 de la zone dopée 140 et/ou 150 est par exemple comprise entre 1 µm et 5 µm, préférentiellement entre 2 µm et 4 µm.

Le transistor T défini par les éléments décrits ci-dessus constitue ainsi un transistor à effet de champ, c'est-à-dire un composant électronique susceptible, en fonction d'une tension de commande appliquée entre la grille 120 et la borne de source S, de former, dans le caisson 130, un canal conducteur connectant électriquement les régions de drain et de source 140 et 150.

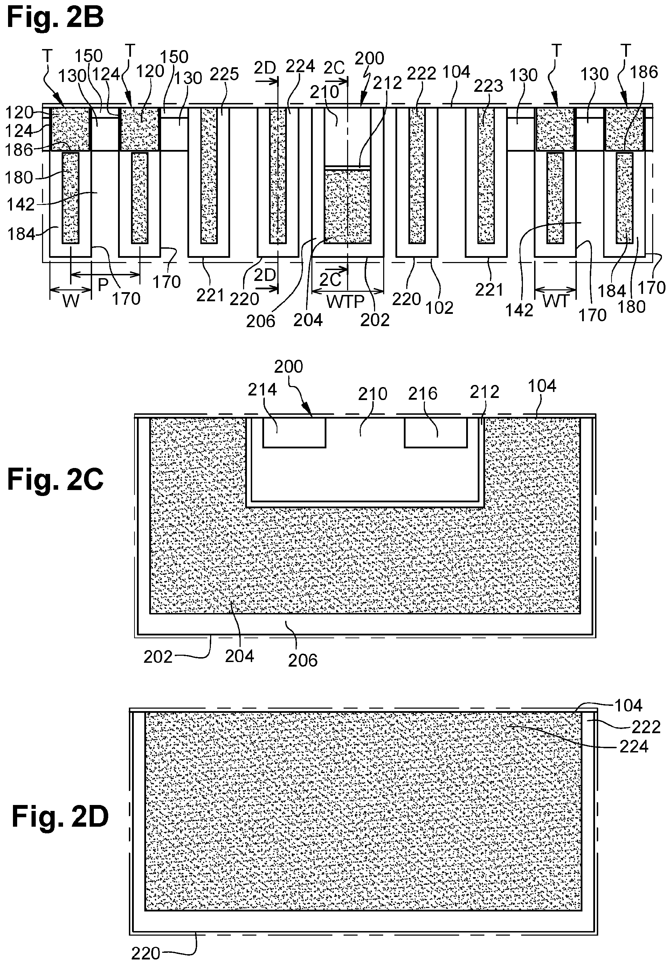

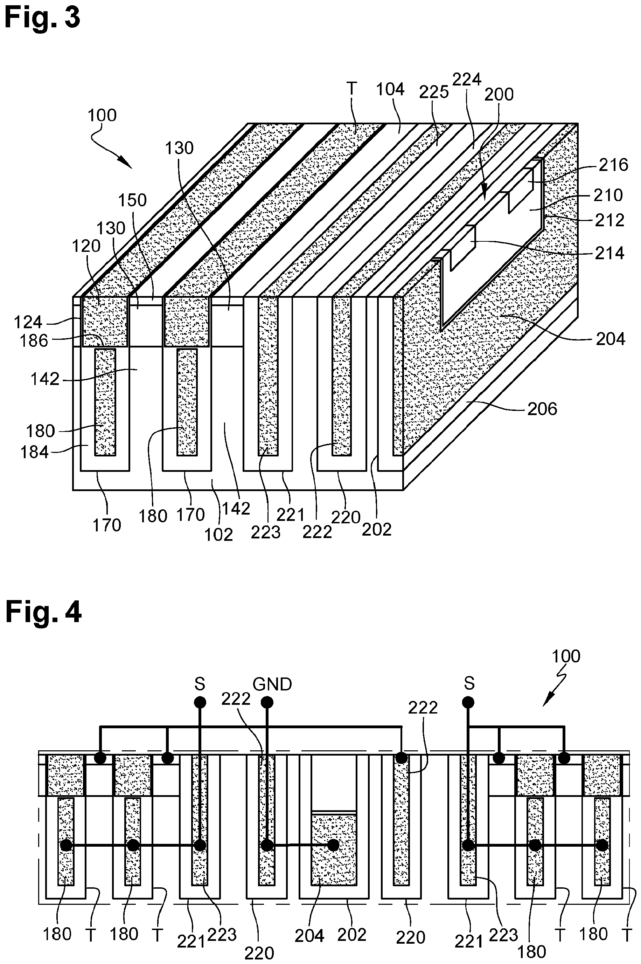

Les figures 2A, 2B, 2C, et 2D représentent, de manière partielle et schématique, respectivement une vue de dessus, et des vues en coupe d'un mode de réalisation d'un dispositif 100 comprenant plusieurs transistors T ayant chacun la structure représentée en figure 1. Les vues en coupe 2B, 2C, et 2D ont pour plans de coupe respectifs des plans 2B-2B, 2C-2C, et 2D-2D. La figure 3 représente une vue en perspective avec coupe, schématique et partielle, de la moitié du dispositif 100. Les transistors T sont représentés partiellement sur les figures 2A à 2D et 3. En particulier, la zone de drain 140 de chaque transistor T, la prise de contact 134 du caisson 130, et la région de dérive 152 ne sont pas représentées sur les figures 2A à 2D et 3.

Le dispositif 100 est typiquement une puce électronique de circuit intégré, définie par le substrat semiconducteur 102 et des éléments, tels que des composants électroniques, situés dans et sur le substrat 102.

Dans un exemple, le substrat 102 est constitué par une tranche semiconductrice, par exemple une tranche de silicium. Dans un autre exemple, le substrat est constitué par une couche située sur la surface d'une tranche semiconductrice, par exemple une couche épitaxiée sur une tranche semiconductrice. De préférence, le substrat 102 est monocristallin.

Les transistors T sont délimités par des tranchées 170, appelées tranchées de transistor 170 par la suite, quatre tranchées de transistor 170 parallèles étant représentées à titre d'exemple sur les figures 2A, 2B, 2C, et 2D. Chaque tranchée de transistor 170 s'étend dans le substrat 102 à partir de la face avant 104 du substrat 102, et une paroi latérale de la tranchée de transistor 170 constitue une face latérale du caisson 130 de l'un des transistors T. De ce fait, chaque tranchée de transistor 170 peut délimiter les faces latérales des caissons 130 de deux transistors T. La profondeur de chaque tranchée de transistor 170 peut être comprise entre 1,5 µm et 2,5 µm, par exemple égale à environ 2 µm. On appelle W, la largeur de la tranchée de transistor 170. A titre d'exemple, chaque tranchée de transistor 170 a une largeur W comprise entre 0,1 µm et 1 µm, par exemple égale à 0,6 µm. De préférence, les tranchées de transistor 170 s'étendent au moins en partie selon des directions parallèles et sont espacées de façon régulière. On appelle alors P le pas des tranchées de transistor 170. Le pas P peut être compris entre 1 µm et 1,4 µm.

La grille 120 de chaque transistor T comprend au moins une région conductrice électriquement s'étendant dans la tranchée de transistor 170, tel que par exemple un métal et/ou du silicium polycristallin dopé. L'isolant de grille 124 est en contact avec le caisson 130 et avec la région conductrice de la grille 120. L'isolant de grille 124 est typiquement constitué d'une ou plusieurs couches diélectriques, par exemple l'isolant de grille est constitué d'une couche d'oxyde de silicium. L'épaisseur de l'isolant de grille 124 est typiquement inférieure à 15 nm, de préférence comprise entre 3 nm et 10 nm. De préférence, la grille 120 est commune aux deux transistors T délimités par la même tranchée de transistor 170.

A titre d'exemple, le transistor T est du type à canal P. Ainsi, les zones dopées 140 et 150 sont dopées de type P. Le caisson 130 est dopé de type N. Cependant, dans les modes de réalisation décrits, les types de conductivité N et P, ou types de dopage, peuvent être échangés. Des fonctionnements similaires à ceux décrits sont alors obtenus en échangeant les signes des tensions dans le dispositif. De préférence, les niveaux de dopage des zones 140 et 150 sont élevés, c'est-à-dire supérieurs à 5*10¹⁸ atomes/cm³, de préférence supérieurs à 10¹⁹ atomes/cm³. La prise de contact 134, non représentée sur les figures 2A à 2D et 3, avec le caisson 130 est une zone dopée ayant également un tel niveau de dopage élevé. Le niveau de dopage du caisson 130 est de préférence inférieur à 10¹⁸ atomes/cm³, plus préférentiellement inférieur à 5*10¹⁷ atomes/cm³. Chaque région semiconductrice 142, 152 a un niveau de dopage de type P inférieur à celui de la zone dopée 150 de type P. De préférence, chaque région semiconductrice 142, 152 a un niveau de dopage faible, c'est-à-dire inférieur à 2*10¹⁷ atomes/cm³. Ce niveau de dopage est de préférence supérieur à 5*10¹⁶ atomes/cm³.

Le dispositif 100 peut comprendre, en outre, pour chaque tranchée de transistor 170, un élément électriquement conducteur 180 situé dans la tranchée de transistor 170. L'élément conducteur 180 est connecté à une borne non représentée sur les figures 2A à 2D et 3. Cette borne est de préférence connectée à la borne de corps. L'élément conducteur 180 est situé en vis-à-vis d'au moins une partie de la région semiconductrice 142, c'est-à-dire que l'élément conducteur 180 est situé contre un isolant 184 recouvrant la face latérale d'au moins une partie de la région semiconductrice 142. La couche isolante 184 sépare l'élément conducteur 180 de la région semiconductrice 142. La distance entre l'élément conducteur 180 et la région semiconductrice 142, correspondant à l'épaisseur de la couche isolante 184, est par exemple comprise entre 100 nm et 200 nm, de préférence, comprise entre 120 nm et 180 nm. La couche isolante 184 a de préférence une épaisseur supérieure à celle de l'isolant de grille 124. A titre d'exemple, la couche isolante 184 est en oxyde de silicium ou en nitrure de silicium.

Au fond de la tranchée de transistor 170, une portion isolante, de préférence une portion de la couche isolante 184, est située sous l'élément conducteur 180. Cette portion isole électriquement l'élément conducteur 180 de la partie du substrat 102 située sous l'élément conducteur 180. En outre, des couches isolantes 186, de préférence du même matériau ou matériaux que l'isolant de grille 124, isolent électriquement l'élément conducteur 180 de la grille 120.

De préférence, l'élément conducteur 180 est constitué par un mur conducteur situé dans une partie centrale de la tranchée de transistor 170. Le mur est allongé dans la même direction que la tranchée. Le mur s'étend dans le substrat 102 orthogonalement à la face avant 104 du substrat. A titre d'exemple, le mur comprend, de préférence est constitué par, un matériau métallique ou, préférentiellement, du silicium polycristallin dopé. La largeur du mur conducteur, prise dans la direction de largeur de la tranchée, est par exemple comprise entre 30 nm et 200 nm.

Selon un mode de réalisation, en fonctionnement, les sources S et les éléments conducteurs 180 sont électriquement reliés, de préférence connectés, entre eux.

Selon un mode de réalisation, le dispositif 100 comprend, en outre, un composant électronique supplémentaire 200 différent du transistor T. Ce composant électronique 200 peut faire partie d'un circuit de commande et/ou de protection des transistors T.

Le dispositif 100 comprend une tranchée 202 contenant au moins en partie le composant électronique 200 et appelée tranchée de composant 202 par la suite. La tranchée de composant 202 s'étend dans le substrat 102 à partir de la face avant 104 du substrat 102. Le dispositif 100 comprend un élément conducteur électriquement 204, tel que par exemple un métal et/ou du silicium polycristallin dopé, situé dans la tranchée de composant 202 et une couche isolante 206 qui sépare l'élément conducteur 204 du substrat 102. A titre d'exemple, la couche isolante 206 est en oxyde de silicium ou en nitrure de silicium. La largeur de l'élément conducteur 204 peut être comprise entre 0,15 µm et 0,2 µm. La profondeur de la tranchée de composant 202 peut être comprise entre 1,5 µm et 2,5 µm, par exemple égale à environ 2 µm. De préférence, la profondeur de la tranchée de composant 202 est égale à la profondeur de la tranchée de transistor 170. On appelle WTP la largeur de la tranchée de composant 202.

Le composant électronique 200 s'étend dans l'élément conducteur 204 depuis la face avant 104 du substrat 102. Le composant électronique 200 comprend une région semiconductrice 210 dopé d'un premier type de conductivité qui s'étend dans l'élément conducteur 204 depuis la face avant 104 du substrat 102 et qui est isolée électriquement de l'élément conducteur 204 par une couche isolante 212. A titre d'exemple, la couche isolante 212 est en oxyde de silicium ou en nitrure de silicium. Le composant électronique 200 comprend en outre une région semiconductrice 214 dopée du premier type de conductivité et plus fortement dopée que la région semiconductrice 210, et une région semiconductrice 216 dopée d'un deuxième type de conductivité, opposé au premier type de conductivité, les régions semiconductrices 214 et 216 s'étendant chacune dans la région semiconductrice 210 depuis la face avant 104. Les régions dopées 214, 216 peuvent notamment être connectées à des pistes conductrices électriquement et former les bornes du composant électronique 200. La profondeur de la région semiconductrice 210 peut être comprise entre 0,6 µm et 1 µm, par exemple égale à environ 0,8 µm. La largeur de la région semiconductrice 210 peut être sensiblement égale à la largeur de l'élément conducteur 204, par exemple être comprise entre 0,15 µm et 0,2 µm ou égale à la largeur de la région 120.

Selon un mode de réalisation, le composant électronique 200 est une diode. La région semiconductrice 210 peut être faiblement dopée d'un premier type de conductivité, par exemple de type P, la région semiconductrice 214 peut être dopée du premier type de conductivité, plus fortement dopée que la région semiconductrice 210 et la région semiconductrice 214 peut être dopée d'un deuxième type de conductivité opposé au premier type de conductivité, par exemple de type N, et plus fortement dopée que la région semiconductrice 210. Selon un autre mode de réalisation, le composant électronique 200 est une résistance. Les régions semiconductrices 210, 212, et 214 peuvent être dopées du premier type de conductivité, les régions 212 et 214 étant plus fortement dopées que la région semiconductrice 210. Le niveau de dopage de la région semiconductrice 210 est de préférence inférieur à 10¹⁸ atomes/cm³, plus préférentiellement inférieur à 5*10¹⁷ atomes/cm³. De préférence, les niveaux de dopage des régions semiconductrices 140 et 150 sont élevés, c'est-à-dire supérieurs à 5*10¹⁸ atomes/cm³, de préférence supérieurs à 10¹⁹ atomes/cm³.

Le dispositif 100 comprend en outre des premières tranchées 220 et des deuxièmes tranchées 221 intercalées entre la tranchée de composant 202 et les tranchées de transistor 170, et appelées tranchées de protection 220, 221 par la suite, les tranchées de protection 220 étant plus proches de la tranchée de composant 202 que les tranchées de protection 221. Les tranchées 220 et 221 peuvent avoir la même structure. Chaque tranchée de protection 220, 221 s'étend dans le substrat 102 à partir de la face avant 104 du substrat 102. Pour chaque tranchée de protection 220, 221, le dispositif 100 comprend un élément électriquement conducteur 222, tel que par exemple un métal et/ou du silicium polycristallin dopé, situé dans la tranchée de protection 220 et une couche isolante 224 qui sépare l'élément conducteur 222 du substrat 102 et un élément électriquement conducteur 223, tel que par exemple un métal et/ou du silicium polycristallin dopé, situé dans la tranchée de protection 221 et une couche isolante 225 qui sépare l'élément conducteur 223 du substrat 102. A titre d'exemple, la couche isolante 224, 225 est en oxyde de silicium. Le dispositif 100 comprend au moins la tranchée de protection 220, de préférence au moins la tranchée de protection 220 et la tranchée de protection 221 entre la tranchée de composant 202 et la tranchée de transistor 170 la plus proche. La profondeur de chaque tranchée de protection 220, 221 peut être comprise entre 1,8 µm et 2,2 µm, par exemple égale à environ 2 µm. De préférence, la profondeur de chaque tranchée de protection 220, 221 est égale à la profondeur de la tranchée de transistor 170. On appelle WT la largeur de la tranchée de protection 220, 221. De préférence, la largeur WT est sensiblement égale à la largeur W. La largeur WTP est supérieure ou égale à la largeur WT. De préférence, la largeur WTP est supérieure strictement à la largeur WT. La largeur de l'élément conducteur 222, 223 peut être comprise entre 0,15 µm et 0,2 µm.

Le dispositif 100 comprend en outre des pistes conductrices et des vias conducteurs, non représentés, d'au moins un niveau de métallisation formé sur la face avant 104 du substrat 102 pour la connexion des sources et des caissons des transistors T et la connexion du composant 200.

De préférence, la tranchée de protection 221 entoure complètement la zone du substrat 102 contenant les tranchées de transistor 170. De préférence, la tranchée de protection 220 entoure complètement la zone du substrat 102 contenant le composant électronique 200. Dans le mode de réalisation du dispositif 100 représenté sur les figures 2A à 2D et 3, les transistors T sont présents de part et d'autre du composant électronique 200. A titre de variante, les transistors T peuvent n'être présents que d'un côté de la tranchée de composant 202.

La figure 4 est une vue en coupe, partielle et schématique, analogue à la figure 2B illustrant un mode de réalisation des connexions des éléments du dispositif 100. Les connexions peuvent être réalisées par les pistes métalliques des niveaux de métallisation du dispositif 100 qui sont représentées de façon schématique par des traits et disques noirs sur la figure 4.

Selon un mode de réalisation, l'élément conducteur 222 présent dans chaque tranchée de protection 220 est connecté électriquement à l'élément conducteur 204 présent dans la tranchée de composant 202. Selon un mode de réalisation, l'élément conducteur 204 présent dans la tranchée de composant 202 est connecté à la source du potentiel de référence bas du dispositif 100, par exemple la masse GND. Selon un mode de réalisation, l'élément conducteur 222 présent dans chaque tranchée de protection 220 est également connecté électriquement à la source du potentiel de référence bas GND du dispositif 100. A titre de variante, l'élément conducteur 222 présent dans chaque tranchée de protection 220 peut être connecté électriquement à une borne de source S commune des transistors T, notamment dans le cas où le composant électronique 200 n'est pas entouré par les tranchées de transistor 170. Selon une autre variante, lorsque le composant électronique 200 est une diode, l'élément conducteur 222 présent dans chaque tranchée de protection 220 peut être connecté électriquement à la cathode 214 de la diode 200 et à la l'élément conducteur 204, notamment lorsque la diode 200 et sa tranchée de protection 220 sont entourées par les tranchées de transistor 170. Selon un mode de réalisation, lorsque les tranchées de protection 221 sont présentes entre la tranchée de composant 202 et la tranchée de transistor 170 la plus proche, l'élément conducteur 223 présent dans la tranchée de protection 221 est connecté électriquement à une borne de source S commune des transistors T. Les éléments conducteurs 180 des transistors T peuvent également être connecté électriquement à la borne de source S. Le potentiel de référence bas GND et le potentiel à la source S peuvent être différents.

Les tranchées de protection 220, 221 autour du composant 200 permettent, de façon avantageuse, de maintenir un potentiel électrostatique bas sensiblement constant à proximité du composant électronique 200, en particulier un potentiel électrostatique qui ne varie pas avec le potentiel des sources, des grilles, des drains et des caissons des transistors T.

A titre d'exemple, le drain des transistors T peut être amenés en fonctionnement à un potentiel de 40 V à 45 V. Lorsque les transistors T sont à l'état passant, la tension entre la grille et la source de chaque transistor T est d'environ 10 V et le potentiel à la source est d'environ 40 V-45 V. Les éléments conducteurs 222 des tranchées de protection 220 et l'élément conducteur 204 de la tranchée de composant 202 sont mis à environ 40 V-45 V. Lorsque les transistors T sont à l'état non passant, la tension entre la grille et la source de chaque transistor T est d'environ 0 V et le potentiel à la source est d'environ 0 V. Les éléments conducteurs 222 des tranchées de protection 220 et l'élément conducteur 204 de la tranchée de composant 202 sont à environ 0 V.

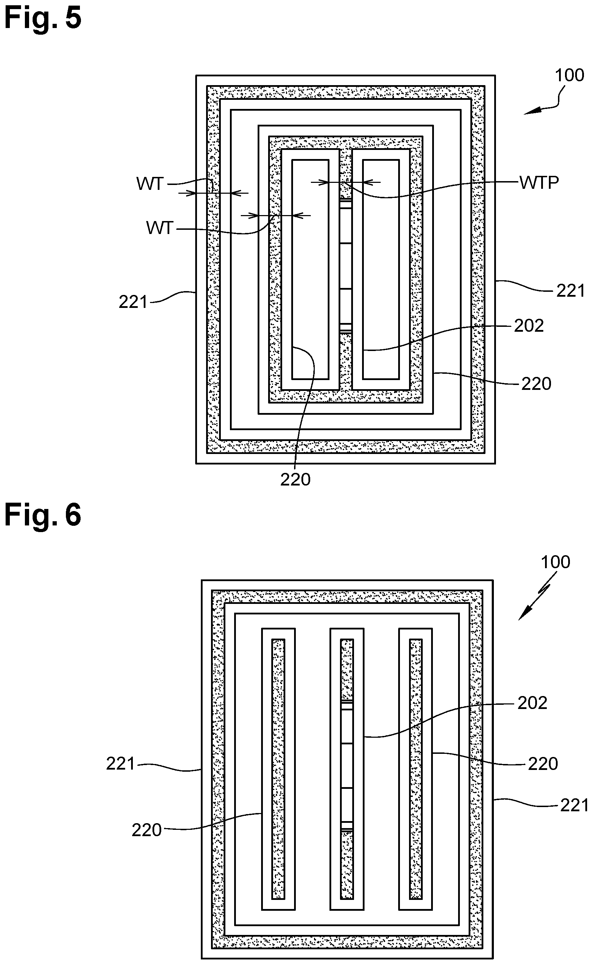

Les figures 5 et 6 sont des vues de dessus, partielles et schématiques, de modes de réalisation de structures aux extrémités longitudinales de la tranchée de composant 202 du dispositif 100 représenté sur les figures 2A à 2D et 3. Sur les figures 5 et 6, la largeur WTP de la tranchée de composant 202 est égale à la largeur WT de chaque tranchée de protection 220 et 221. Les tranchées de protection 221 les plus éloignées de la tranchée de composant 202 se rejoignent aux extrémités de façon à entourer complètement la tranchée de composant 202. Ceci signifie que les éléments conducteurs 223 des tranchées de protection 221 sont connectés ensemble aux extrémités.

Dans le mode de réalisation de la figure 5, les tranchées de protection 220 les plus proches de la tranchée de composant 202 se rejoignent aux extrémités de façon à entourer complètement la tranchée de composant 202, la tranchée de composant 202 rejoignant également aux extrémités les tranchées de protection 220. Ceci signifie que les éléments conducteurs 222 dans les tranchées de protection 220 sont connectés ensemble aux extrémités et également connectés aux extrémités de l'élément conducteur 204 contenu dans la tranchée de composant 202. Dans le mode de réalisation de la figure 6, les tranchées de protection 220 les plus proches de la tranchée de composant 202 sont disjointes et s'étendent parallèlement à la tranchée de composant 202.

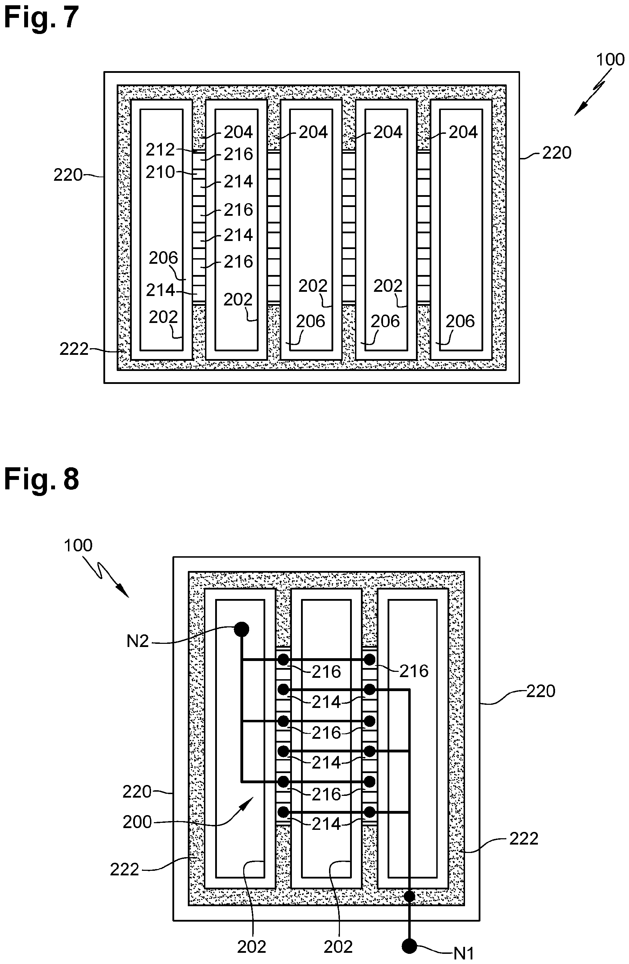

La figure 7 est une vue de dessus, partielle et schématique, d'une variante du dispositif électronique 100. Selon cette variante, le dispositif 100 comprend N tranchées de composant 202, N étant un nombre entier supérieur à 2, par exemple pouvant varier de 2 à 4. Les N tranchées de composant 202 peuvent s'étendre de façon parallèle. Chaque tranchée de composant 202 contient l'élément électriquement conducteur 204 situé dans la tranchée de composant 202, la couche isolante 206 qui sépare l'élément conducteur 204 du substrat 102, la région semiconductrice 210 dopée du premier type de conductivité qui s'étend dans l'élément conducteur 204 depuis la face avant 104 du substrat 102 et qui est isolée électriquement de l'élément conducteur 204 par une couche isolante 212. Le composant électronique 200 comprend en outre, pour chaque tranchée de composant 202, M régions semiconductrices 214 dopées du premier type de conductivité et plus fortement dopées que la région semiconductrice 210 et M régions semiconductrices 216 dopées du deuxième type de conductivité et plus fortement dopées que la région semiconductrice 210, M étant un nombre entier supérieur à 2, par exemple variant de 2 à 60. Les régions 214 et 216 sont alternées selon la direction longitudinale de la tranchée de composant 202 et s'étendent chacune dans la région semiconductrice 210 depuis la face avant 104. De préférence, les régions semiconductrices 214, 216 situées aux deux extrémités longitudinales de la région semiconductrice 210 sont de types de conductivité opposées. Les alternances des régions semiconductrices 214, 216 entre deux tranchée de composant 202 adjacentes peuvent être inversées. Les connexions des régions semiconductrices 214 et des régions semiconductrices 216 dépendent des propriétés souhaitées du composant électronique 200.

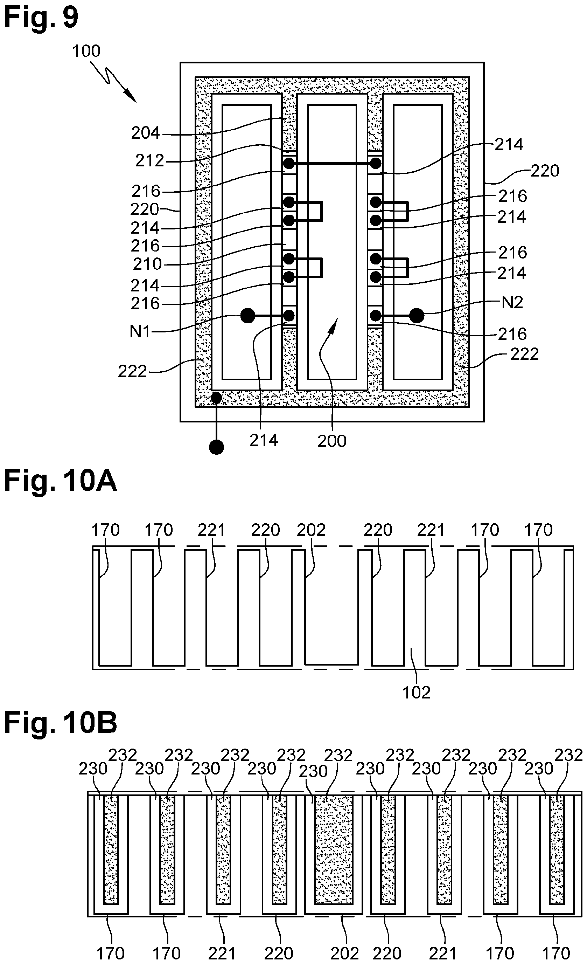

Les figures 8 et 9 sont chacune une vue en coupe latérale, partielle et schématique, analogue à la figure 2B illustrant un mode de réalisation des connexions des éléments du dispositif 100 représenté sur la figure 7 dans le cas où le dispositif 100 comprend des première et deuxième tranchées de composant 202, chacune comprenant une alternance de trois régions semiconductrices 214 dopées de type P et trois régions semiconductrices 216 dopées de type N. Les connexions peuvent être réalisées par les pistes métalliques des niveaux de métallisation du dispositif 100 qui sont représentées de façon schématique par des traits et disques noirs sur les figures 8 et 9.

Dans le mode de réalisation illustré en figure 8, les régions semiconductrices 214 des première et deuxième tranchées de composant 202 sont connectées en parallèle et les régions semiconductrices 216 des première et deuxième tranchées de composant 202 sont connectées en parallèle. Les régions semiconductrices 214 sont connectées à la première borne N1 du composant 200 et les régions semiconductrices 216 sont connectées à la deuxième borne N2 du composant 200. Dans le cas où, en fonctionnement, les régions semiconductrices 214 sont destinées à être connectées à la source du potentiel de référence bas du dispositif 100, les régions semiconductrices 214 peuvent en outre être connectées à l'élément conducteur 222 des tranchées de protection 220 les plus proches des tranchées de composant 202.

Dans le mode de réalisation illustré en figure 9, les régions semiconductrices 214 et les régions semiconductrices 216 sont connectées en série. Ceci signifie que chaque région semiconductrice 214 est connectée électriquement en série à une région semiconductrice 214. Pour chaque tranchée de composant 202, à l'exception des régions semiconductrices 214 et 216 situées aux extrémités de la tranchée de composant 202 chaque région semiconductrice 214 de la tranchée de composant 202 est connectée en série à la région semiconductrice 216 la plus proche de la même tranchée de composant 202. La région semiconductrice 216 située à une première extrémité de la première tranchée de composant 202 est connectée en série à la région semiconductrice 214 située à une première extrémité de la deuxième tranchée de composant 202. La région semiconductrice 214 située à la deuxième extrémité de la première tranchée de composant 202 est connectée à la première borne N1 du composant 200 et la région semiconductrice 216 située à la deuxième extrémité de la deuxième tranchée de composant 202 est connectée à la deuxième borne N2 du composant 200. L'élément conducteur 222 des tranchées de protection 220 les plus proches des tranchées de composant 202 peut être connecté à la source du potentiel de référence bas du dispositif 100.

Les figures 10A à 10H sont des vues en coupe, partielles et schématiques, de structures obtenues à des étapes d'un mode de réalisation d'un procédé de fabrication du dispositif 100 des figures 2A à 2D.

La figure 10A représente la structure obtenue après la formation des tranchées de transistor 170, des tranchées de protection 220, 221 et de la tranchée de composant 202 dans le substrat 102. Les tranchées 170, 202, 220, et 221 peuvent être réalisées par une même étape de gravure.

La figure 10B représente la structure obtenue après la formation, sur les parois et le fond de chaque tranchée 170, 202, 220, et 221 d'une couche isolante 230 et d'un coeur conducteur 232. Le procédé peut comprendre un dépôt conforme d'une couche isolante recouvrant la structure résultant de la gravure des tranchées 170, 202, 220, et 221, le dépôt d'une couche conductrice, par exemple en silicium polycristallin, recouvrant la couche isolante et remplissant l'espace restant de chaque tranchée 170, 202, 220, et 221, et le retrait, par exemple par gravure, des parties de la couche isolante et de la couche conductrice situées en dehors des tranchées 170, 202, 220, et 221. A titre de variante, les couches isolantes 230 peuvent être formées par une étape d'oxydation thermique. L'épaisseur de la couche isolante 230 correspond à l'épaisseur souhaitée pour chaque couche isolante 184, chaque couche isolante 206, et chaque couche isolante 224, 225. Les murs de protection contenus dans les tranchées de protection 220 et 221 sont alors formés.

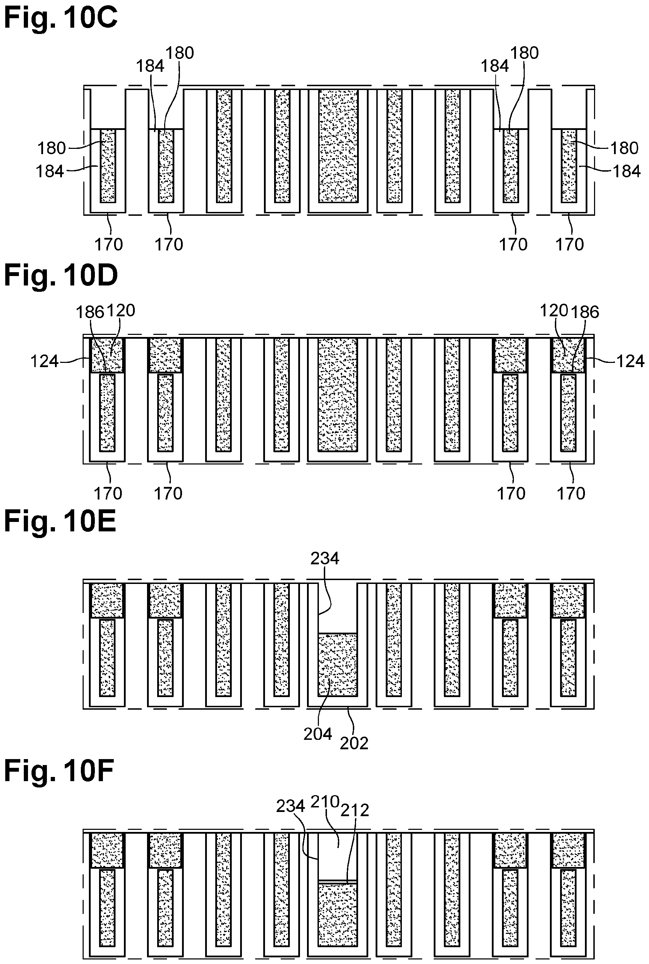

La figure 10C représente la structure obtenue après la gravure, sur une partie de la profondeur de chaque tranchée de transistor 170, de la couche isolante 230 et du coeur conducteur 232. Les éléments conducteurs 180 et les couches isolantes 184 des transistors sont ainsi formés.

La figure 10D représente la structure obtenue après la formation, dans chaque tranchée de transistor 170, de la couche isolante 186, de l'isolant de grille 124 et de la grille 120. L'isolant de grille 124 peut être formé par oxydation thermique. Le procédé peut comprendre un dépôt d'une couche conductrice recouvrant la couche isolante et remplissant l'espace restant de chaque tranchée de transistor 170, et le retrait, par exemple par gravure, des parties de la couche conductrice situées en dehors des tranchées de transistor 170.

La figure 10E représente la structure obtenue après la gravure d'une ouverture 234 dans le coeur conducteur 232 présent dans la tranchée de composant 202. L'élément conducteur 204 est ainsi délimité.

La figure 10F représente la structure obtenue après la formation de la couche isolante 212, notamment au fond de l'ouverture 234, et la formation de la région semiconductrice 210. La formation de la couche isolante 212 peut comprendre une étape d'oxydation entraînant en outre la formation de couches isolantes sur le reste de la structure. La formation de la région semiconductrice 210 peut comprendre le dépôt, sur l'ensemble de la structure, d'une couche semiconductrice, par exemple du silicium polycristallin, remplissant notamment l'espace restant de la tranchée de composant 202, une étape d'implantation de dopants d'un premier type de conductivité, par exemple de type P, dans la couche semiconductrice pour obtenir le dopage souhaité pour la région semiconductrice 210, et le retrait, par exemple par gravure, des parties de la couche semiconductrice en dehors de la tranchée de composant 202.

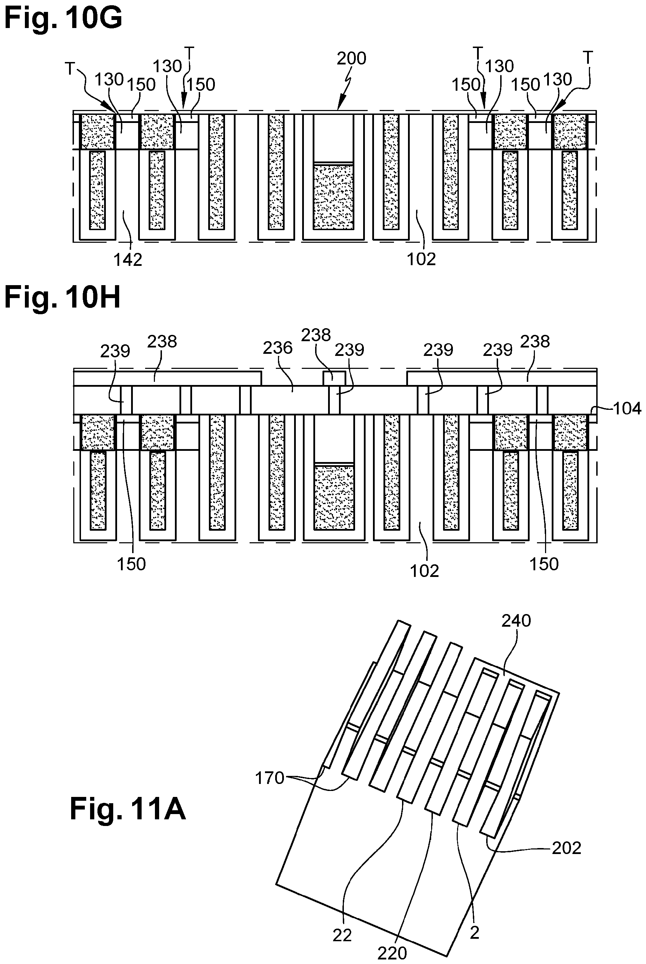

La figure 10G représente la structure obtenue après une étape d'implantation de dopants d'un deuxième type de conductivité, par exemple de type N, pour former les caissons 130 des transistors et des étapes d'implantation de dopants du premier type de conductivité et du deuxième type de conductivité, pour former les régions de source 150, les régions de drain 140, et les régions de dérive 142 des transistors (les régions de drain 142 n'étant pas représentées en figure 10G) et les régions 212 et 214 fortement dopées, non représentées en figure 10G. Les transistors T et le composant électronique 200 sont ainsi formés.

La figure 10H représente la structure obtenue après une étape de formation des niveaux de métallisation, un seul niveau de métallisation étant représenté en figure 10H. A titre d'exemple, on a représenté en figure 10H une couche isolante 236 recouvrant la face avant 104 du substrat 102, des pistes métalliques 238 s'étant sur la couche isolante 236, et de vias conducteurs 239 traversant la couche isolante 236 et connectant les pistes métalliques 238 notamment aux régions semiconductrices 150, 214, et 216.

Les figures 11A à 11H sont des vues en perspective, partielles et schématiques, analogues respectivement aux figures 10A à 10H, de structures obtenues à des étapes d'un mode de réalisation d'un procédé de fabrication du dispositif 100 avec la structure d'extrémité de la tranchée de composant 202 décrite précédemment en relation avec la figure 7 avec deux tranchées de composant 202, et une seule tranchée de protection 220 à droite des tranchées de composant 202.

La figure 11A est analogue à la figure 10A décrite précédemment, un masque 240 utilisé pour la gravure des tranchées 170, 202, 220, et 221 étant représenté en figure 11A.

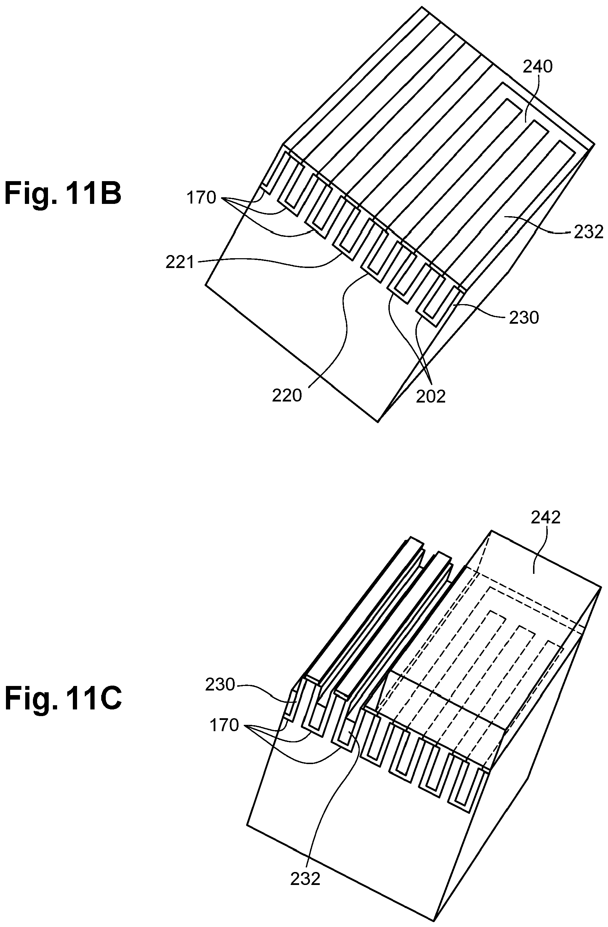

La figure 11B est analogue à la figure 10B décrite précédemment, le masque 240 étant conservé lors de la formation de la couche isolante 230 et du coeur conducteur 232 pour chaque tranchée 170, 202, 220 et 221.

La figure 11C est analogue à la figure 10C décrite précédemment, un masque 242 utilisé pour la gravure du coeur conducteur 232 sur une partie de la profondeur de chaque tranchée de transistor 170 étant représenté en figure 11C, la gravure de la couche isolante 230 sur une partie de la profondeur de chaque tranchée de transistor 170 n'étant pas encore réalisée en figure 11C.

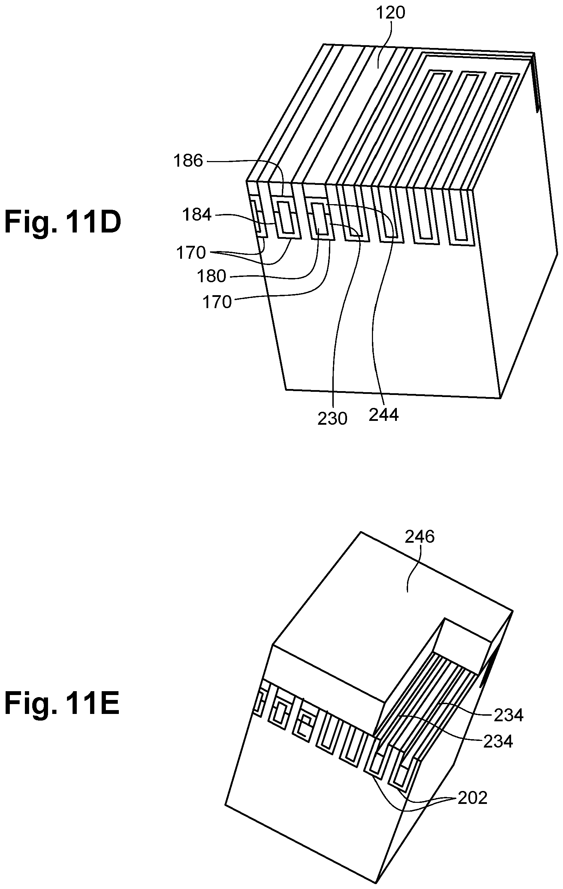

La figure 11D est analogue à la figure 10D. Comme cela apparaît sur cette figure, pour chaque tranchée de transistor 170, la couche isolante 230 a été gravée sur une profondeur supérieure à la profondeur de gravure du coeur isolant 232. Ceci peut se produire selon le type de gravure utilisé. La formation de la couche isolante 186 comprend alors la formation d'une couche isolante 244 recouvrant les parois latérales exposées de l'élément conducteur 180 et la paroi supérieure de l'élément conducteur 180. La couche isolante 184 et la couche isolante 186 sont ainsi formées.

La figure 11E est analogue à la figure 10E décrite précédemment, un masque 246 utilisé pour la gravure d'une ouverture 234 dans le coeur conducteur 232 de chaque tranchée de composant 202 étant représenté en figure 11E. La formation du masque 246 peut être précédée d'une étape de gravure de l'ensemble de la structure depuis la face avant pour retirer le masque 240.

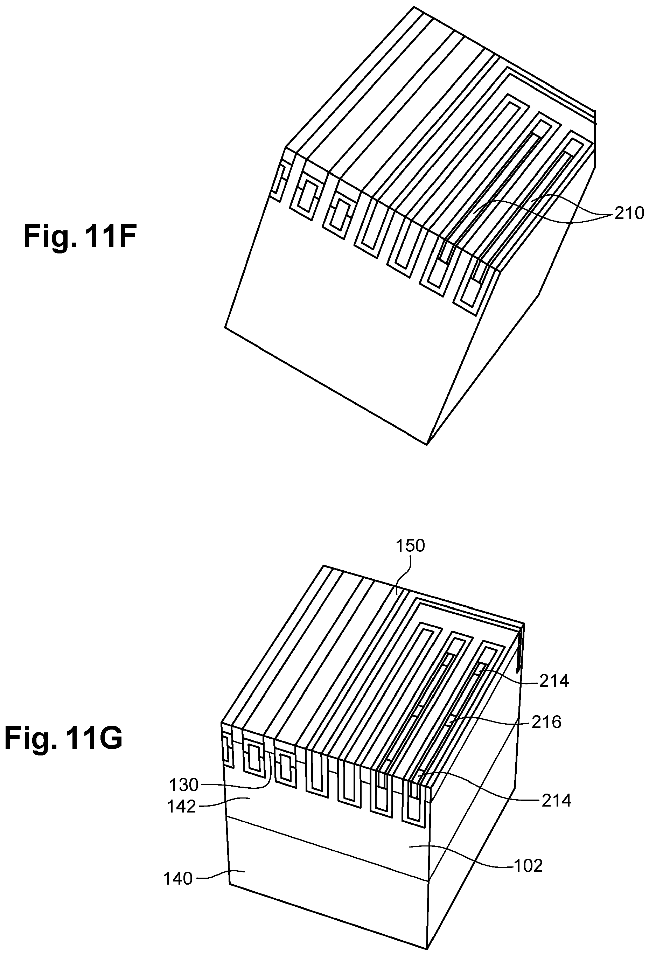

La figure 11F est analogue à la figure 10F décrite précédemment, et la figure 11G est analogue à la figure 10G décrite précédemment.

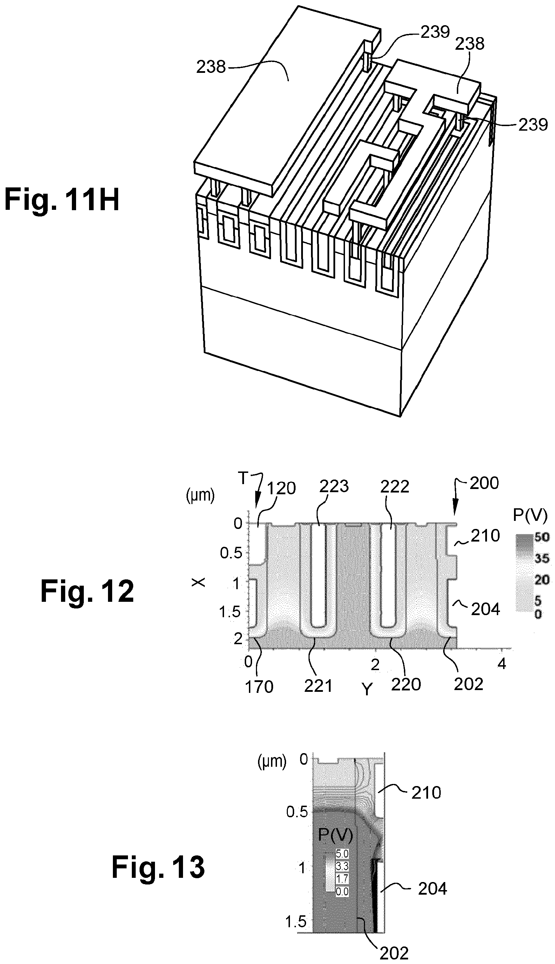

La figure 11H est analogue à la figure 10H décrite précédemment, la couche isolante 236 n'étant pas représentée sur la figure 11H.

Des simulations ont été réalisées pour le dispositif 100 représenté sur les figures 2A à 2D pour mettre en évidence la protection conférée par les murs contenus dans les tranchées de protection 202. Pour toutes les simulations, les éléments conducteurs 222 présents dans les tranchées de protection 220 et l'élément conducteur 204 présent dans la tranchée de composant 202 sont à 0 V. Les simulations correspondent aux situations en fonctionnement normal où des potentiels maximum et minimum sont appliqués aux transistors T.

Les figures 12 à 17 sont des vues en coupe latérale, partielles et schématiques, du dispositif 100 illustrant, par des niveaux de gris, les potentiels P dans le dispositif 100. Les figures 13, 15, et 17 sont des vues agrandies respectivement des figures 12, 14, et 16.

Les figures 12 et 13 illustrent une première simulation dans laquelle les transistors T sont à l'état passant. Le drain de chaque transistor T était à un potentiel d'environ 40 V, la tension entre la grille et la source de chaque transistor T était est d'environ 0 V, et le potentiel à la source de chaque transistor T était d'environ 0 V.

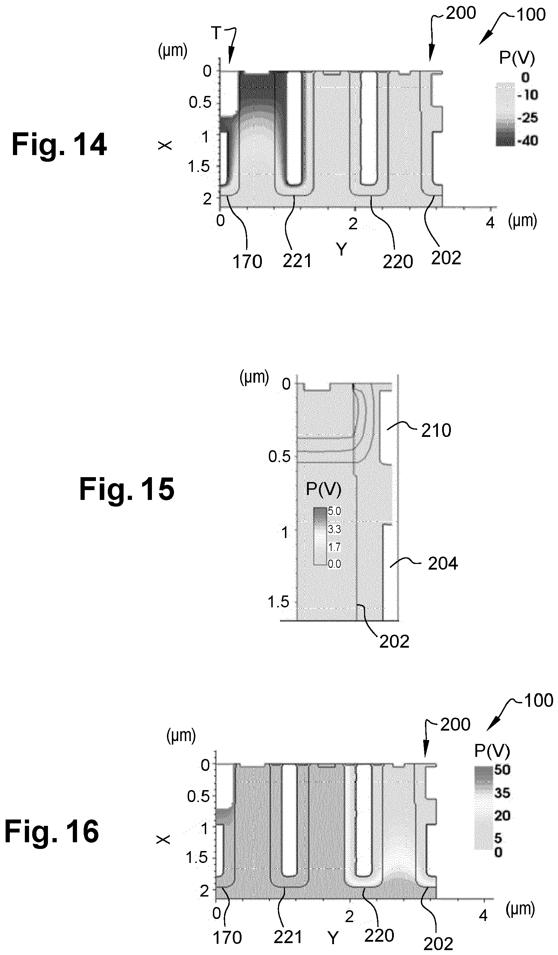

Les figures 14 et 15 illustrent une deuxième simulation dans laquelle les transistors T sont à l'état non passant. Le drain de chaque transistor T était à un potentiel d'environ 40 V, la tension entre la grille et la source de chaque transistor T était d'environ 0 V, et le potentiel à la source de chaque transistor T était d'environ 0 V.

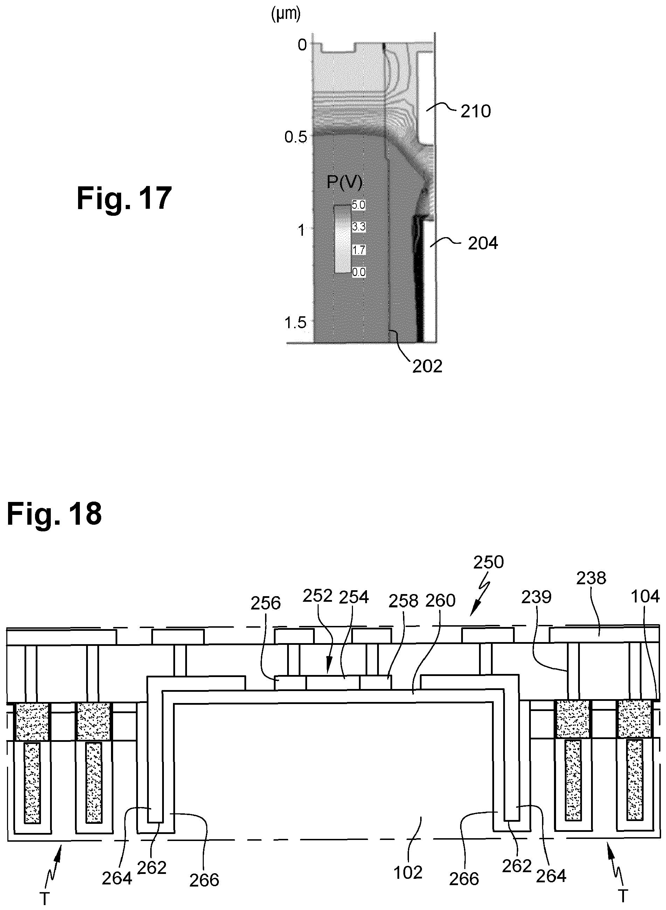

Les figures 16 et 17 illustrent une troisième simulation correspondant à une déconnexion de l'alimentation du dispositif 100. Le drain de chaque transistor T était à un potentiel d'environ 0 V, la tension entre la grille et la source de chaque transistor T était d'environ -40 V, et le potentiel à la source de chaque transistor T était d'environ -40 V.

Comme cela apparaît sur les figures 12 à 17, le potentiel autour de la région semiconductrice 210 contenue dans la tranchée de composant 202 reste sensiblement égal à 0 V quels que soient les potentiels appliqués aux transistors T. Le fonctionnement du composant électronique 200 n'est donc pas perturbé par le fonctionnement des transistors T.

La figure 18 est une vue en coupe, partielle et schématique, d'un dispositif 250 comprenant l'ensemble des éléments du dispositif 100 à la différence que le composant électronique 200 n'est pas présent, mais est remplacé par un composant électronique 252 situé sur la face avant 104 du substrat 102. A titre d'exemple, le composant 250 comprend une bande de silicium polycristallin 254 éventuellement dopé dans laquelle sont formées des régions semiconductrices 256, 258 plus fortement dopées de types de conductivité opposées. La bande de silicium polycristallin 254 est séparée du substrat 102 par une couche isolante 260.

Le dispositif 250 comprend en outre des tranchées 262, qui s'étendent dans le substrat 102 à partir de la face avant 104 du substrat 102. Pour chaque tranchée 262, le dispositif 250 comprend un élément électriquement conducteur 264 situé dans la tranchée 260 et une couche isolante 266 qui sépare l'élément conducteur 262 du substrat 102. Les tranchées 262 délimitent les régions du substrat 102 contenant les transistors T et permettent d'assurer le maintien des potentiels dans les régions du substrat 102 contenant les transistors T. Le composant 252 est formé sur une région du substrat ne contenant pas de transistors T.

Un avantage du dispositif 100 par rapport au dispositif 250 est que la réalisation du composant 200 est simultanée à celle des transistors T. En particulier, certaines des étapes de fabrication du composant 200, notamment la gravure de la tranchée de composant 202 et des tranchées de protection 220, la formation des éléments conducteurs 204, 222, 223, les étapes d'implantations de dopants pour la formation des régions semiconductrices 214 et 216 sont communes à celles déjà mises en oeuvre lors de la fabrication des transistors T. Au contraire, la fabrication du composant 252 requiert des étapes supplémentaires de dépôts, de gravures, d'implantations de dopants, etc., par rapport au procédé de fabrication des transistors T puisqu'elles doivent être mises en oeuvre après la fabrication des transistors T.

En outre, lorsque le composant 200, 252 est une diode utilisée pour mesurer la température des transistors T, le dispositif 100 présente l'avantage que la distance séparant le composant 200 des transistors T est réduite par rapport à la distance séparant le composant 252 des transistors T. Ceci permet de façon avantageuse une détection plus juste de la température des transistors T. En outre, ceci permet de façon avantageuse une détection plus rapide d'un changement de la température des transistors T.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les transistors T ont été décrits avec un caisson 130 connecté à une borne B de caisson du transistor pour la polarisation du caisson. A titre de variante, les caissons 130 peuvent être laissés flottants dans l'espace entre la tranchée de composant 202 et la tranchée de protection et dans l'espace entre les tranchées de protection 220 et 221.

Enfin, la mise en oeuvre pratique des modes de réalisation et variantes décrits est à la portée de l'homme du métier à partir des indications fonctionnelles données ci-dessus.

## Revendications

1. Dispositif électronique (100) comprenant un substrat semiconducteur (102), des transistors (T) dont les grilles (120) sont contenues dans des premières tranchées (170) s'étendant dans le substrat et au moins un composant électronique (200), différent d'un transistor, formé au moins en partie dans une première région semiconductrice (210) contenue dans une deuxième tranchée (202) s'étendant dans le substrat semiconducteur parallèlement aux premières tranchées.

2. Dispositif électronique selon la revendication 1, comprenant, en outre :
- un premier élément conducteur électriquement (204) situé dans la deuxième tranchée (202), la première région semiconductrice (210) s'étendant dans le premier élément conducteur électriquement ;
- une première couche isolante électriquement (206) entre le premier élément conducteur électriquement et le substrat semiconducteur (102) ; et
- une deuxième couche isolante électriquement (212) entre la première région semiconductrice et le premier élément conducteur électriquement.

3. Dispositif électronique selon la revendication 2, comprenant, en outre :
- au moins une troisième tranchée (220) s'étendant dans le substrat semiconducteur (102) au moins sur une partie le long de la deuxième tranchée (202), entre la deuxième tranchée et l'une des premières tranchées (170) ;
- un deuxième élément conducteur électriquement (222) contenu dans la troisième tranchée ; et
- une troisième couche isolante électriquement (224) entre le deuxième élément conducteur électriquement et le substrat semiconducteur.

4. Dispositif électronique selon la revendication 3, comprenant deux troisièmes tranchées (220) s'étendant dans le substrat semiconducteur (102) de part et d'autre de la deuxième tranchée (202).

5. Dispositif électronique selon la revendication 3 ou 4, dans lequel chaque troisième tranchée (220) est totalement disjointe de la deuxième tranchée (202).

6. Dispositif électronique selon la revendication 3 ou 4, dans lequel chaque troisième tranchée (220) rejoint à chaque extrémité la deuxième tranchée (202), le deuxième élément conducteur électriquement (222) étant jointif avec le premier élément conducteur électriquement (204).

7. Dispositif électronique selon l'une quelconque des revendications 3 à 6, comprenant, en outre :
- une quatrième tranchée (221) s'étendant dans le substrat semiconducteur (102) et entourant complètement la deuxième tranchée (202) et chaque troisième tranchée (220), les premières tranchées étant du côté de la quatrième tranchée opposé à la deuxième tranchée ;
- un troisième élément conducteur électriquement (223) contenu dans la quatrième tranchée ; et
- une quatrième couche isolante électriquement (225) entre le troisième élément conducteur électriquement et le substrat semiconducteur.

8. Dispositif électronique selon l'une quelconque des revendications 1 à 7, dans lequel chaque transistor (T) comprend :
- une cinquième couche isolante électriquement (124) entre la grille (120) du transistor et le substrat semiconducteur (102) et formant l'isolant de grille du transistor ;
- un quatrième élément conducteur électriquement (180) situé dans la première tranchée (170) ;
- une sixième couche isolante électriquement (184) entre le quatrième élément conducteur électriquement et le substrat semiconducteur ;
- une septième couche isolante électriquement (186) entre le quatrième élément conducteur électriquement et la grille ;
- une deuxième région semiconductrice (150) du substrat semiconducteur (102), délimitée par la première tranchée (170) contenant la grille ; et
- un caisson semiconducteur (130) en contact avec la deuxième région semiconductrice et l'isolant de grille, et dans lequel est situé le canal du transistor.

9. Dispositif électronique selon l'une quelconque des revendications 1 à 8, dans lequel la première région semiconductrice (210) est dopée d'un premier type de conductivité, le dispositif électronique comprenant, en outre, au moins des troisième et quatrième régions semiconductrices (214, 216) s'étendant dans la première région semiconductrice et plus fortement dopées que la première région semiconductrice.

10. Dispositif électronique selon la revendication 9, comprenant des deuxièmes tranchées (202) s'étendant dans le substrat semiconducteur (102) et des premières régions semiconductrices (210) contenues chacune dans l'une des deuxièmes tranchées, chaque première région semiconductrice (210) étant dopée d'un premier type de conductivité, le dispositif électronique comprenant, en outre, des troisième et quatrième régions semiconductrices (214, 216) s'étendant dans chaque première région semiconductrice et plus fortement dopées que les premières régions semiconductrices.

11. Dispositif électronique selon la revendication 9, comprenant des troisièmes régions semiconductrices (214) et des quatrièmes régions semiconductrices (216) s'étendant dans la première région semiconductrice et plus fortement dopées que la première région semiconductrice.

12. Dispositif électronique selon la revendication 11, dans lequel les troisièmes régions semiconductrices (214) sont connectées électriquement en parallèle et dans lequel les quatrièmes régions semiconductrices (216) sont connectées électriquement en parallèle.

13. Dispositif électronique selon la revendication 11, dans lequel au moins l'une des troisièmes régions semiconductrices (214) est connectée électriquement en série à l'une des quatrièmes régions semiconductrices (216).

14. Dispositif électronique selon la revendication 9, dans lequel le composant électronique (200) est une diode, la troisième région semiconductrice (214) étant dopée du premier type de conductivité et la quatrième région semiconductrice (216) étant dopée d'un deuxième type de conductivité opposé au premier type de conductivité.

15. Dispositif électronique selon la revendication 9, dans lequel le composant électronique (200) est une résistance, les troisième et quatrième régions semiconductrices (214, 216) étant dopées du premier type de conductivité.

16. Procédé de fabrication du dispositif électronique (100) selon l'une quelconque des revendications 1 à 15, dans lequel les premières tranchées (170) et la deuxième tranchée (202) sont formées simultanément.

17. Utilisation du dispositif électronique (100) selon la revendication 7, dans laquelle, en fonctionnement, le premier élément conducteur électriquement (204) et le deuxième élément conducteur électriquement (222) sont connectés électriquement à une source d'un potentiel de référence (GND).

18. Utilisation selon la revendication 13, le dispositif électronique (100) étant en outre selon la revendication 8 dans son rattachement à la revendication 6, dans laquelle, en fonctionnement, le troisième élément conducteur électriquement (223) est connecté électriquement aux quatrièmes éléments conducteurs électriquement (180).
